# EUROPEAN PATENT APPLICATION

(11) **EP 4 768 930 A1**
(43) Date of publication of application: **01.07.2026**
(21) Application number: 25214925.7
(22) Date of filing: 11.11.2025
(51) Int. Cl.: G01R 31/36, G01R 31/389, G01R 31/392, H01M 10/48

(54) **ANALYZING A BATTERY MODULE FOR POSSIBLE REUSE**

(30) Priority: 31.12.2024 US 202419006427
(71) Applicant: TOYOTA MOTOR ENGINEERING & MANUFACTURING NORTH AMERICA, INC., Plano, TX 75024 (US)
(72) Inventor: ISHIGAKI, Masanori, Plano, 75024 (US)
(74) Representative: J A Kemp LLP

(57) **Abstract**

A system for analyzing a battery module for possible reuse can include a stage, a measuring component, and a parameter analysis component. The stage can be configured to support the battery module that includes a plurality of batteries. The measuring component can be configured to measure, across a range of frequencies, an impedance across the battery module. The parameter analysis component can include a processor and a memory. The memory can store a reuse assessment module. The reuse assessment module can include instructions that cause the processor to: (1) determine a difference between values, at a first frequency and at a second frequency, of a first derivative, with respect to frequency, of a real part of the impedance and (2) determine, responsive to the difference being less than a threshold, that the battery module is suitable for reuse.

## Description

### TECHNICAL FIELD

The disclosed technologies are directed to analyzing a battery module for possible reuse.

### BACKGROUND

An engine of a conventional motor vehicle can, through a combustion process, consume a fossil fuel to produce a propulsion force. Because waste products of the combustion process can include pollutants, efforts have been made to produce the propulsion force through different mechanisms. Among such efforts have been those that can use an electric motor to produce the propulsion force. Such a vehicle can be referred to as an electric vehicle. In an electric vehicle, power to the electric motor can be provided from a battery. However, over a life of a battery, a charge capacity of the battery can become reduced. When the charge capacity of the battery has been reduced below a threshold (e.g., 80 percent of a nominal charge capacity), one or more of a driving range of the electric vehicle or a rate at which the battery recharges can be reduced below a threshold preferred by an operator of the electric vehicle. In this situation, although the charge capacity of the battery can be at an end of a life for use in the electric vehicle, such a charge capacity of the battery may still be sufficient for other uses. Such other uses can be referred to as reuse of the battery.

### SUMMARY

In an embodiment, a system for analyzing a battery module for possible reuse can include a stage, a measuring component, and a parameter analysis component. The stage can be configured to support the battery module that includes a plurality of batteries. The measuring component can be configured to measure, across a range of frequencies, an impedance across the battery module. The parameter analysis component can include a processor and a memory. The memory can store a reuse assessment module. The reuse assessment module can include instructions that cause the processor to: (1) determine a difference between values, at a first frequency and at a second frequency, of a first derivative, with respect to frequency, of a real part of the impedance and (2) determine, responsive to the difference being less than a threshold, that the battery module is suitable for reuse.

In another embodiment, a method for analyzing a battery module for possible reuse can include supporting, by a stage, the battery module that includes a plurality of batteries. The method can include measuring, by a measuring component and across a range of frequencies, an impedance across the battery module. The method can include determining, by a processor, a difference between values, at a first frequency and at a second frequency, of a first derivative, with respect to frequency, of a real part of the impedance. The method can include determining, by the processor responsive to the difference being less than a threshold, that the battery module is suitable for reuse.

In another embodiment, a non-transitory computer-readable medium for analyzing a battery module for possible reuse can include instructions that, when executed by one or more processors, cause the one or more processors to determine a difference between values, at a first frequency and at a second frequency, of a first derivative, with respect to frequency, of a real part of an impedance across the battery module. The impedance can be measured across a range of frequencies. The battery module can include a plurality of batteries. The battery module can be supported by a stage. The non-transitory computer-readable medium can include instructions that, when executed by one or more processors, cause the one or more processors to determine, responsive to the difference being less than a threshold, that the battery module is suitable for reuse.

### BRIEF DESCRIPTION OF THE DRAWINGS

The accompanying drawings, which are incorporated in and constitute a part of the specification, illustrate various systems, methods, and other embodiments of the disclosure. It will be appreciated that the illustrated element boundaries (e.g., boxes, groups of boxes, or other shapes) in the figures represent one embodiment of the boundaries. In some embodiments, one element may be designed as multiple elements or multiple elements may be designed as one element. In some embodiments, an element shown as an internal component of another element may be implemented as an external component and vice versa. Furthermore, elements may not be drawn to scale.
FIG. 1 includes a block diagram that illustrates an example of an environment for analyzing a battery module for possible reuse, according to the disclosed technologies.
FIG. 2 includes a diagram that illustrates an example of a graph of a real part of an impedance of the battery module with respect to frequency.
FIG. 3 includes a diagram that illustrates an example of a graph of a first derivative, with respect to frequency, of the real part of the impedance of the battery module.
FIGS. 4A through 4C include diagrams that illustrate examples of a condition of a change in a position between a metal, of the battery module, and a battery of a plurality of batteries included in the battery module.
FIGS. 5A through 5C include diagrams that illustrate examples of a condition in which a metal, of the battery module, has magnetization characteristics.
FIGS. 6A through 6C include diagrams that illustrate examples of a condition of a change in a contact resistance of a terminal of a battery of a plurality of batteries included in the battery module.
FIGS. 7A through 7C include diagrams that illustrate an example of a condition of solid electrolyte interphase growth.
FIG. 8 includes a diagram that illustrates examples of graphs of imaginary parts of the impedance of the battery module versus real parts of the impedance of the battery module at different phases of lives of a plurality of batteries in the battery module.
FIGS. 9A and 9B include a flow diagram that illustrates an example of a method that is associated with analyzing a battery module for possible reuse, according to the disclosed technologies.

### DETAILED DESCRIPTION

The disclosed technologies are directed to analyzing a battery module for possible reuse. Often, a plurality of batteries, rather than an individual battery, can be used to provide power to a device. For example, such a plurality of batteries can be included in a battery system. For example, a battery system can have a hierarchical configuration. For example, the hierarchical configuration can include a battery module and a battery pack. For example, in a battery module, the plurality of batteries can have an arrangement so that: (1) a charge capacity of at least some of the plurality of batteries (connected in parallel) is greater than a charge capacity of an individual battery, (2) a voltage produced by at least some of the plurality of batteries (connected in series) is greater than a voltage produced by an individual battery, or (3) both. For example, a battery module can include a casing configured to maintain the arrangement of the plurality of batteries in the battery module. For example, the battery module can be configured so that the plurality of batteries in the battery module operate as a unit. For example, the battery module can include a positive terminal for the unit and a negative terminal for the unit. For example, in addition to one or more battery modules, a battery pack can include one or more of a cooling system or a Battery Management System. For example, a Battery Management System can be configured to: (1) monitor one or more parameters of batteries in the battery pack and (2) estimate one or more states (e.g., a state of charge, a state of health, etc.) of the batteries in the battery pack. For example, a battery pack can include a casing configured to meet a form factor requirement of a device to which the battery pack can be used to provide power.

An analysis of a battery for reuse can be based, for example, on values of one or more states of the battery. For example, such states can be figures of merit that indicate one or more current conditions of the battery with respect to one or more nominal conditions. Such figures of merit can include, for example, a state of charge (SOC), a state of health (SOH), a state of safety (SOS), a state of functionality (SOF), and the like. For example, the SOC can be an indicator of energy currently within a battery. For example, a value of the SOC can be expressed as a quotient of a current charge capacity of the battery divided by a nominal charge capacity (e.g., a charge capacity at a beginning of life (BOL)) of the battery. For example, the SOH can be an indicator of a phase of a life of a battery. For example, a value of the SOH can be expressed as a quotient of a current maximum available charge capacity of the battery divided by a nominal charge capacity of the battery. For example, an end of life (EOL) of the battery can be a specific percentage of the SOH. Alternatively, for example, the value of the SOH can be expressed as a quotient of a first difference divided by a second difference. For example, the first difference can be an internal resistance of the battery at the EOL subtracted from a current internal resistance of the battery. For example, the second difference can be the internal resistance of the battery at the EOL subtracted from a nominal internal resistance (e.g., an internal resistance at the BOL) of the battery. For example, the SOS can be an indicator that can quantify a degree to which a battery can be considered to be in a safe state. For example, a value of the SOS can be expressed as a distribution function with values that range from zero (certain unsafe state) to one (certain safe state). For example, the value of the SOS for the battery can be a product of values of SOSs of individual variables associated with the battery. For example, such individual variables can include temperature, current, voltage, SOC, and the like. For example, the SOF can be an indicator of a power output capability of a battery. For example, a value of the SOF can be proportional to a product of the value of the SOH multiplied by the value of the SOS.

For example, one condition that can reduce a degree to which a battery can be considered to be in a safe state can be a development of metal plating within the battery. Metal plating can be a condition, internal to the battery, in which a superficial layer forms on an anode from improper intercalation of ions into an anode material. For example, in a case in which the battery is a lithium-ion battery, then the superficial layer can be lithium ions that accumulate on a surface of the anode. This superficial layer can reduce overall power generation by the lithium-ion battery.

For example, a high-frequency electrochemical impedance spectroscopy (HF-EIS) diagnostic technique can be used to assess the degree to which the battery can be considered to be in a safe state. For example, the HF-EIS diagnostic technique can include measurements of an impedance of the battery across a range of frequencies. For example, for a specific frequency at which the impedance of the battery is measured, the impedance can be related to a process occurring within the battery over a duration of time that is an inverse of the specific frequency. For example, changes in the measurements of the impedance of the battery across the range of frequencies can be indicative of occurrences of processes within the battery that affect one or more states of the battery. For example, because of a usefulness of the HF-EIS diagnostic technique, some types of electric vehicle batteries can include monitoring circuits configured to operate to perform the HF-EIS diagnostic technique. Such a monitoring circuit can be referred to as an impedance tracking sensor. However, currently and for a foreseeable future, most electric vehicle batteries can lack such impedance tracking sensors. A situation in which most electric vehicle batteries lack impedance tracking sensors can present at least two problems in assessing the values of one or more states of such electric vehicle batteries for possible reuse. First, equipment for the HF-EIS diagnostic technique can be expensive. Second, a performance of the HF-EIS diagnostic technique can be difficult to accomplish for an individual battery that is one of a plurality of batteries included within a casing of a battery module.

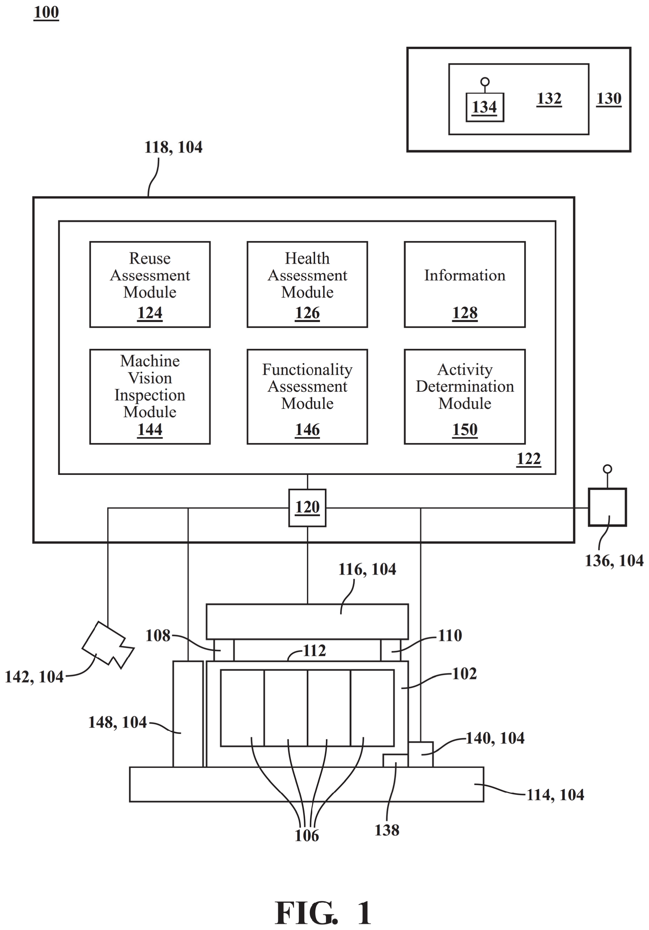

FIG. 1 includes a block diagram that illustrates an example of an environment 100 for analyzing a battery module 102 for possible reuse, according to the disclosed technologies. The environment 100 can include, for example, the battery module 102 and a system 104 for analyzing the battery module 102 for possible reuse.

For example, the battery module 102 can include a plurality of batteries 106. For example, the battery module 102 can be configured so that the plurality of batteries 106 in the battery module 102 operate as a unit. For example, the battery module 102 can include a positive terminal 108 for the unit and a negative terminal 110 for the unit. For example, the battery module 102 can further include a casing 112 configured to maintain an arrangement of the plurality of batteries 106. For example, the plurality of batteries 106 can include electric vehicle batteries. Additionally or alternatively, for example, the plurality of batteries 106 can include lithium-ion batteries.

The system 104 can include, for example, a stage 114, a measuring component 116, and a parameter analysis component 118. For example, the stage 114 can be configured to support the battery module 102. For example, the measuring component 116 can be configured to measure, across a range of frequencies, an impedance across the battery module 102 (e.g., between the positive terminal 108 and the negative terminal 110). For example, the measuring component 116 can exclude an impedance tracking sensor. For example, the parameter analysis component 118 can include a processor 120 and a memory 122. The memory 122 can be communicably coupled to the processor 120. For example, the memory 122 can store a reuse assessment module 124.

For example, the reuse assessment module 124 can include instructions that function to control the processor 120 to: (1) determine a difference between values, at a first frequency and at a second frequency, of a first derivative, with respect to frequency, of a real part of the impedance across the battery module 102 and (2) determine, responsive to the difference being less than a threshold, that the battery module 102 may be suitable for reuse. For example, the difference can be an estimate of a value of a state of safety (SOS) of the battery module 102. For example, the difference being greater than the threshold can be indicative of a development of metal plating within the battery module 102. For example, both the first frequency and the second frequency can be greater than a third frequency. For example, the third frequency can be a frequency at which breakdown of chemicals within the batteries occurs and an effect of ions increases.

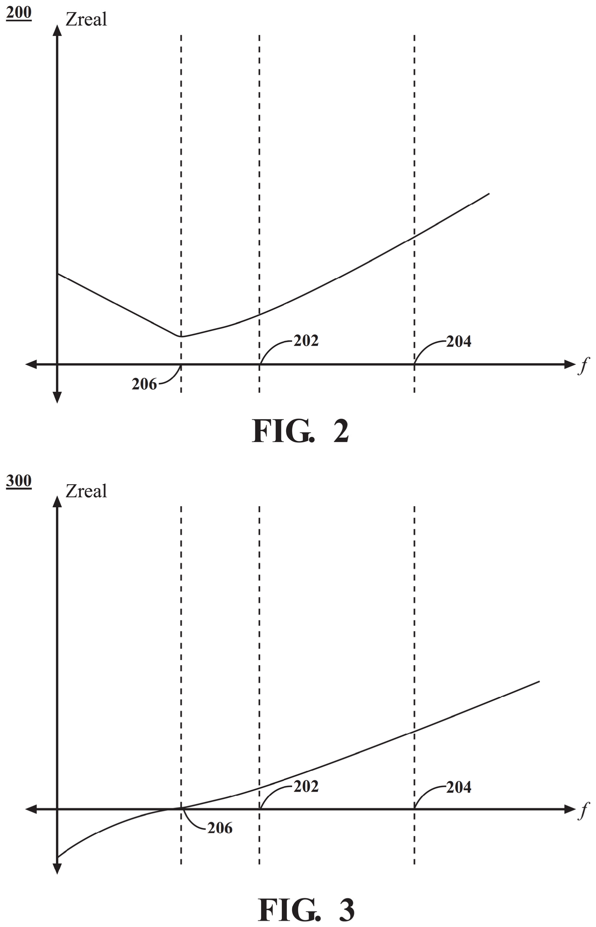

FIG. 2 includes a diagram that illustrates an example of a graph 200 of the real part of the impedance of the battery module 102 with respect to frequency. For example, the graph 200 can include the first frequency 202, the second frequency 204, and the third frequency 206.

FIG. 3 includes a diagram that illustrates an example of a graph 300 of the first derivative, with respect to frequency, of the real part of the impedance of the battery module 102. For example, the graph 300 can include the first frequency 202, the second frequency 204, and the third frequency 206.

Returning to FIG. 1, for example, using the first derivative of the real part of the impedance of the battery module 102 can mitigate an effect of a condition that interferes with a determination of the estimate of the value of the state of safety. For example, the condition can include one or more of: (1) a condition of a change in a position between a metal, of the battery module 102, and a battery of the plurality of batteries 106, (2) a condition in which a metal, of the battery module 102, has magnetization characteristics, (3) a condition of a change in a contact resistance of a terminal of a battery of the plurality of batteries 106, (4) a condition of solid electrolyte interphase growth, or (5) the like.

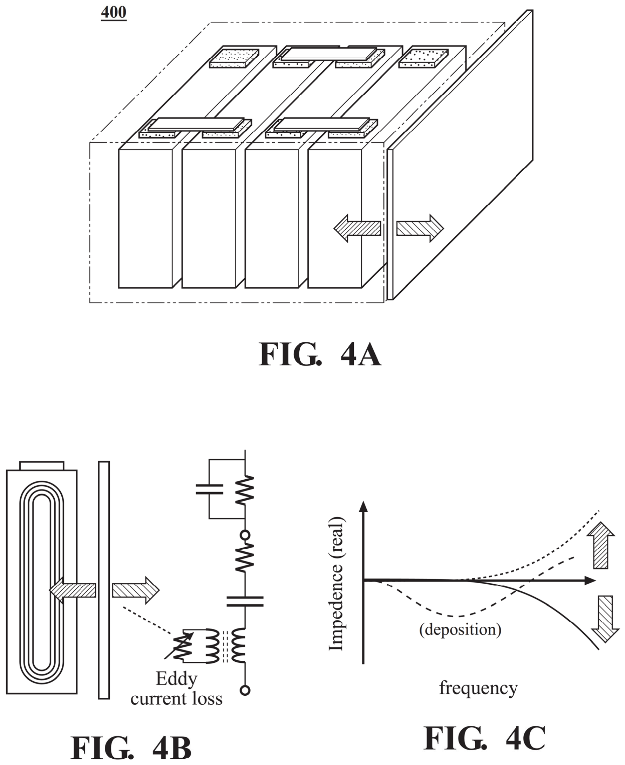

FIGS. 4A through 4C include diagrams 400 that illustrate examples of a condition of a change in a position between a metal, of a battery module, and a battery of a plurality of batteries included in the battery module. For example, FIG. 4A includes a three-dimensional image of the examples of the condition, FIG. 4B includes a two-dimensional image of the examples of the condition and a circuit that illustrates a theoretical behavior caused by the examples of the condition, and FIG. 4C includes a graph, of a real part of an impedance of the battery module as a function of frequency, that illustrates changes to the real part of the impedance caused by the examples of the condition.

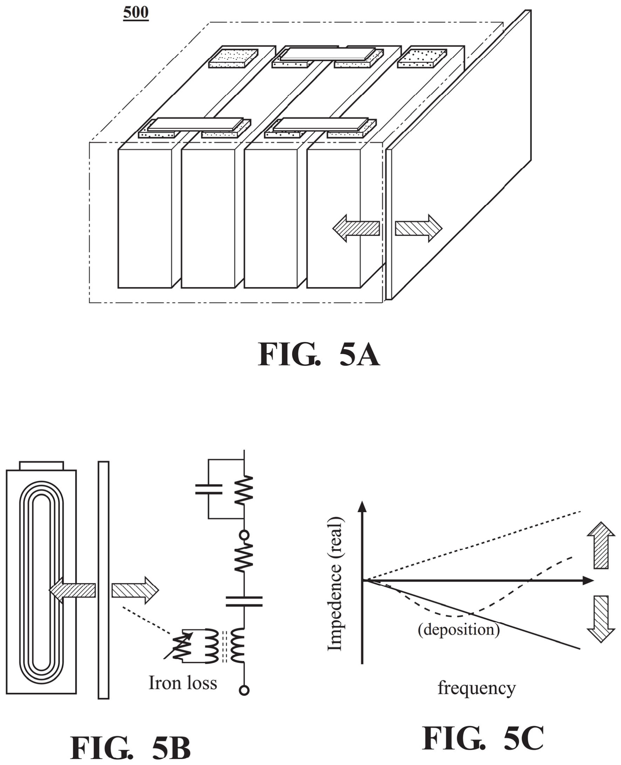

FIGS. 5A through 5C include diagrams 500 that illustrate examples of a condition in which a metal, of the battery module, has magnetization characteristics. For example, FIG. 5A includes a three-dimensional image of the examples of the condition, FIG. 5B includes a two-dimensional image of the examples of the condition and a circuit that illustrates a theoretical behavior caused by the examples of the condition, and FIG. 5C includes a graph, of a real part of an impedance of the battery module as a function of frequency, that illustrates changes to the real part of the impedance caused by the examples of the condition.

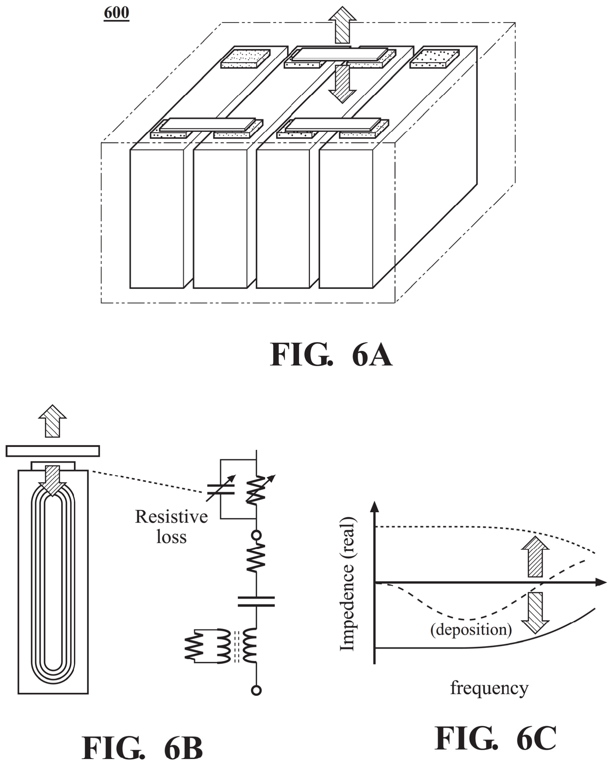

FIGS. 6A through 6C include diagrams 600 that illustrate examples of a condition of a change in a contact resistance of a terminal of a battery of a plurality of batteries included in the battery module. For example, FIG. 6A includes a three-dimensional image of the examples of the condition, FIG. 6B includes a two-dimensional image of the examples of the condition and a circuit that illustrates a theoretical behavior caused by the examples of the condition, and FIG. 6C includes a graph, of a real part of an impedance of the battery module as a function of frequency, that illustrates changes to the real part of the impedance caused by the examples of the condition.

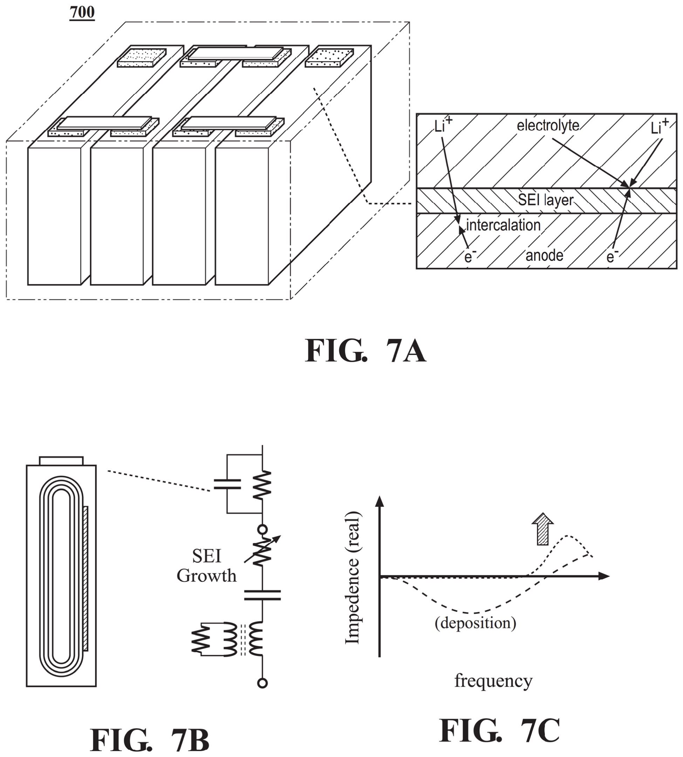

FIGS. 7A through 7C include diagrams 700 that illustrate an example of a condition of solid electrolyte interphase growth. For example, FIG. 7A includes a three-dimensional image and a breakout two-dimensional view that illustrates an example of the condition, FIG. 7B includes a two-dimensional image of the example of the condition and a circuit that illustrates a theoretical behavior caused by the example of the condition, and FIG. 7C includes a graph, of a real part of an impedance of the battery module as a function of frequency, that illustrates changes to the real part of the impedance caused by the example of the condition. Note that in FIG. 7C the change to the real part of the impedance can be more pronounced at higher frequencies.

Returning to FIG. 1, additionally, for example, the memory 122 can further store a health assessment module 126. For example, the health assessment module 126 can include instructions that function to control the processor 120 to determine, from information 128, an estimate of a value of a state of health (SOH) of the battery module 102. For example, the instructions to determine the difference (e.g., the estimate of the value of the SOS) and the instructions to determine the estimate of the value of the SOH can be configured to be performed concurrently.

For example, the environment 100 can further include a battery pack 130. For example, the battery pack 130 can be a battery pack from which the battery module 102 was removed. For example, the battery pack 130 can include a Battery Management System 132. For example, the Battery Management System 132 can be configured to record the information 128 for the battery module 102. For example, the Battery Management System 132 can include a communications component 134. For example, the system 104 can further include a communications component 136. The communications component 136 can be communicably coupled to the processor 120. For example, the communications component 136 can be configured to receive the information 128 from the communications component 134. For example, the system 104 can be configured to store the information 128 in the memory 122.

Additionally or alternatively, for example, the battery module 102 can further include a memory 138. For example, the information 128 can be stored in the memory 138. For example, the system 104 can further include a communications circuit 140. For example, the communications circuit 140 can be configured to cause the information 128 to read from the memory 138 of the battery module 102. For example, the system 104 can be configured to store the information 128 in the memory 122.

For example, the information can include one or more of: (1) historical usage data of the battery module 102 (e.g., highway operations versus urban operations), (2) location-specific data associated with the battery module 102 (e.g., Minnesota versus Florida), (3) temperature-dependent data associated with the battery module 102 (e.g., winter operations versus summer operations), (4) data associated with a fleet associated with a vehicle associated with the battery module 102 (e.g., a delivery van operated by United Parcel Service, Inc. of Sandy Springs, Georgia), (5) impedance data associated with the battery module 102, (6) a visual inspection of the battery module 102, or (7) the like. For example, the impedance data can have been measured at a frequency less than a third frequency (e.g., less than ten kilohertz). For example, the third frequency can be a frequency at which breakdown of chemicals within the batteries occurs and an effect of ions increases. With reference to FIGS. 2 and 3, for example, the impedance data can have been measured at a frequency less than the third frequency 206.

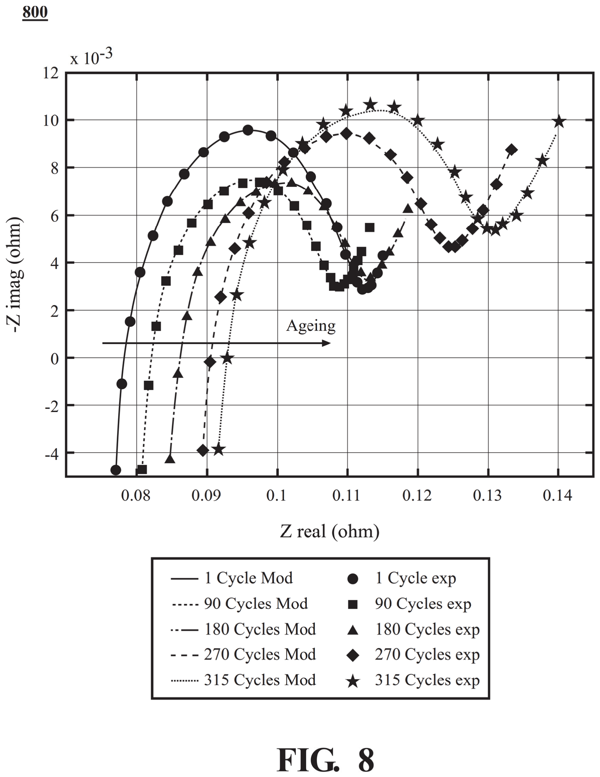

FIG. 8 includes a diagram that illustrates examples of graphs 800 of imaginary parts of the impedance of the battery module 102 versus the real parts of the impedance of the battery module 102 at different phases of lives of the plurality of batteries 106 in the battery module 102.

Returning to FIG. 1, for example, the visual inspection can include a machine vision inspection of an image of the battery module 102. For example, the system 104 can further include an imaging component 142. For example, the imaging component 142 can be configured to produce the image of the battery module 102. For example, the memory 122 can further store a machine vision inspection module 144. For example, the machine vision inspection module 144 can include instructions that function to control the processor 120 to perform the machine vision inspection of the image of the battery module 102.

Additionally or alternatively, for example, the information 128 can include one or more of: (1) the impedance across the battery module 102, (2) a measure of a voltage of the battery module 102, (3) a measure of a temperature of the battery module 102, or (4) the like. For example, the measuring component 116 can be further configured to measure the information 128.

For example, the estimate of the value of the SOH above a first threshold can be indicative that the battery module 102 may be suitable for reuse in a building. For example, the estimate of the value of the SOH above a second threshold can be indicative that the battery module 102 may be suitable for reuse in a vehicle. For example, the second threshold can be greater than the first threshold.

Additionally, for example, the memory 122 can further store a functionality assessment module 146. For example, the functionality assessment module 146 can include instructions that function to control the processor 120 to multiply the estimate of the value of the SOS by the estimate of the value of the SOH to produce an estimate that is proportional to a value of a state of functionality (SOF) of the battery module 102. For example, a value of the SOF can be proportional to a product of the value of the SOH multiplied by the value of the SOS. More specifically, for example, the functionality assessment module 146 can include instructions that function to control the processor 120 to multiply the estimate of the value of the SOS by the estimate of the value of the SOH by a weighting factor to produce an estimate of the value of the SOF of the battery module 102. For example, the weighting factor can depend on one or more of a cellular structure of a battery of the plurality of batteries 106, a material of the casing 112, an application environment, a usage environment (e.g., an electric vehicle), or the like. In this manner, the weighting factor can incorporate and factor additional context associated with the SOF for the battery module 102, which can improve a result of an analysis of the battery module 102 for reuse. For example, the estimate of the value of the SOF above a first value can be indicative that the battery module 102 may be suitable for reuse in an industrial application. For example, the estimate of the value of the SOF above a second value can be indicative that the battery module 102 may be suitable for reuse in a residential application. For example, the estimate of the value of the SOF above a third value can be indicative that the battery module 102 may be suitable for reuse in a commercial application.

Additionally, for example, the system 104 can further include a label affixing component 148. For example, the label affixing component 148 can be configured to affix, to the battery module 102, a label that includes a value of the SOH. For example, the label can include a barcode that represents the value of the SOH. For example, the barcode can include a quick-response (QR) code.

Additionally, for example, the system 104 can further include the imaging component 142. For example, the imaging component 142 can be configured to cause an image, of a label affixed to the battery module 102, to be produced. For example, the label can include information about the SOH. For example, the memory 122 can further store an activity determination module 150. For example, the activity determination module 150 can include instructions that function to control the processor 120 to determine, from the information about the SOH, information useful for one or more of: (1) a maintenance activity to be performed on the battery module 102 or (2) a diagnostic activity to be performed on the battery module 102.

Additionally or alternatively, the battery module 102 can further include the memory 138. For example, the system 104 can further include the communications circuit 140. For example, the communications circuit 140 can be configured to send, to the memory 138 of the battery module 102, the value of the SOH.

Additionally, for example, the battery module 102 can further include the memory 138. For example, the system 104 can further include the communications circuit 140. For example, the communications circuit 140 can be configured to cause information, about the SOH, to be read from the memory 138 of the battery module 102. For example, the memory 122 can further store the activity determination module 150. For example, the activity determination module 150 can include instructions that function to control the processor 120 to determine, from the information about the SOH, information useful for one or more of: (1) a maintenance activity to be performed on the battery module 102 or (2) a diagnostic activity to be performed on the battery module 102.

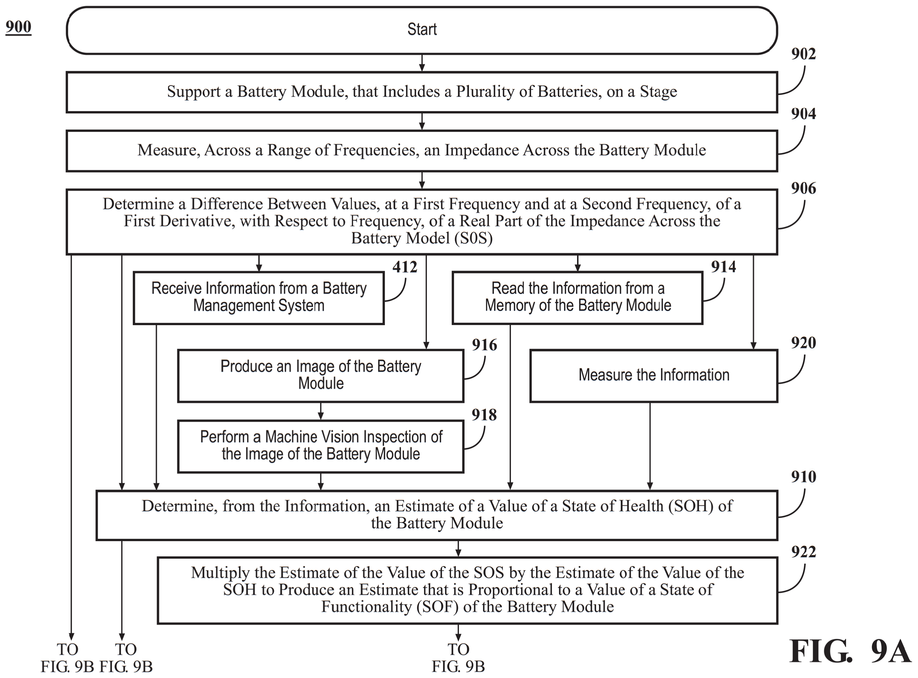

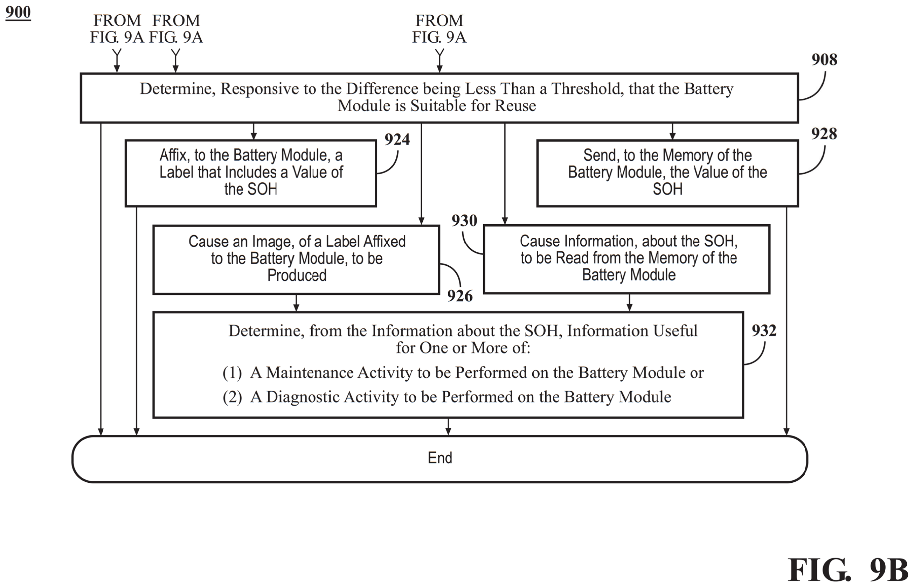

FIGS. 9A and 9B include a flow diagram that illustrates an example of a method 900 that is associated with analyzing a battery module for possible reuse, according to the disclosed technologies. Although the method 900 is described in combination with the system 104 illustrated in FIG. 1, one of skill in the art understands, in light of the description herein, that the method 900 is not limited to being implemented by the system 104 illustrated in FIG. 1. Rather, the system 104 illustrated in FIG. 1 is an example of a system that may be used to implement the method 900. Additionally, although the method 900 is illustrated as a generally serial process, various aspects of the method 900 may be able to be executed in parallel.

In FIG. 9A, in the method 900, at an operation 902, for example, the stage 114 can support the battery module 102 that includes the plurality of batteries 106. For example, the battery module 102 can be configured so that the plurality of batteries 106 in the battery module 102 operate as a unit. For example, the battery module 102 can include the positive terminal 108 for the unit and the negative terminal 110 for the unit. For example, the battery module 102 can further include the casing 112 configured to maintain the arrangement of the plurality of batteries 106. For example, the plurality of batteries 106 can include electric vehicle batteries. Additionally or alternatively, for example, the plurality of batteries 106 can include lithium-ion batteries.

At an operation 904, for example, the measuring component 116 can measure, across a range of frequencies, an impedance across the battery module 102 (e.g., between the positive terminal 108 and the negative terminal 110). For example, the measuring component 116 can exclude an impedance tracking sensor.

At an operation 906, for example, the reuse assessment module 124 can determine a difference between values, at a first frequency and at a second frequency, of a first derivative, with respect to frequency, of a real part of the impedance across the battery module 102.

In FIG. 9B, in the method 900, at an operation 908, for example, the reuse assessment module 124 can determine, responsive to the difference being less than a threshold, that the battery module 102 may be suitable for reuse. For example, the difference can be an estimate of a value of a state of safety (SOS) of the battery module 102. For example, the difference being greater than the threshold can be indicative of a development of metal plating within the battery module 102. For example, both the first frequency and the second frequency can be greater than a third frequency. For example, the third frequency can be a frequency at which breakdown of chemicals within the batteries occurs and an effect of ions increases.

For example, using the first derivative of the real part of the impedance of the battery module 102 can mitigate an effect of a condition that interferes with a determination of the estimate of the value of the state of safety. For example, the condition can include one or more of: (1) a condition of a change in a position between a metal, of the battery module 102, and a battery of the plurality of batteries 106, (2) a condition in which a metal, of the battery module 102, has magnetization characteristics, (3) a condition of a change in a contact resistance of a terminal of a battery of the plurality of batteries 106, (4) a condition of solid electrolyte interphase growth, or (5) the like.

Additionally, in FIG. 9A, in the method 900, at an operation 910, for example, the health assessment module 126 can determine, from information 128, an estimate of a value of a state of health (SOH) of the battery module 102.

For example, the operation 906 and the operation 910 can be performed concurrently.

Additionally, at an operation 912, for example, the communications component 136 can receive the information 128 from the communications component 134. For example, the system 104 can store the information 128 in the memory 122. For example, the environment 100 can further include the battery pack 130. For example, the battery pack 130 can be a battery pack from which the battery module 102 was removed. For example, the battery pack 130 can include the Battery Management System 132. For example, the Battery Management System 132 can be configured to record the information 128 for the battery module 102. For example, the Battery Management System 132 can include the communications component 134.

Additionally or alternatively, at an operation 914, for example, the communications circuit 140 can cause the information 128 to read from the memory 138 of the battery module 102. For example, the system 104 can store the information 128 in the memory 122. For example, the battery module 102 can further include the memory 138.

For example, the information can include one or more of: (1) historical usage data of the battery module 102 (e.g., highway operations versus urban operations), (2) location-specific data associated with the battery module 102 (e.g., Minnesota versus Florida), (3) temperature-dependent data associated with the battery module 102 (e.g., winter operations versus summer operations), (4) data associated with a fleet associated with a vehicle associated with the battery module 102 (e.g., a delivery van operated by United Parcel Service, Inc. of Sandy Springs, Georgia), (5) impedance data associated with the battery module 102, (6) a visual inspection of the battery module 102, or (7) the like. For example, the impedance data can have been measured at a frequency less than a third frequency (e.g., less than ten kilohertz). For example, the third frequency can be a frequency at which breakdown of chemicals within the batteries occurs and an effect of ions increases.

For example, the visual inspection can include a machine vision inspection of an image of the battery module 102. For example, at an operation 916, the imaging component 142 can produce the image of the battery module 102. For example, at an operation 918, the machine vision inspection module 144 can perform the machine vision inspection of the image of the battery module 102.

Additionally or alternatively, for example, the information 128 can include one or more of: (1) the impedance across the battery module 102, (2) a measure of a voltage of the battery module 102, (3) a measure of a temperature of the battery module 102, or (4) the like. For example, at an operation 920, the measuring component 116 can measure the information 128.

For example, the estimate of the value of the SOH above a first threshold can be indicative that the battery module 102 may be suitable for reuse in a building. For example, the estimate of the value of the SOH above a second threshold can be indicative that the battery module 102 may be suitable for reuse in a vehicle. For example, the second threshold can be greater than the first threshold.

Additionally, at an operation 922, for example, the functionality assessment module 146 can multiply the estimate of the value of the SOS by the estimate of the value of the SOH to produce an estimate that is proportional to a value of a state of functionality (SOF) of the battery module 102. For example, a value of the SOF can be proportional to a product of the value of the SOH multiplied by the value of the SOS. More specifically, for example, the functionality assessment module 146 can multiply the estimate of the value of the SOS by the estimate of the value of the SOH by a weighting factor to produce an estimate of the value of the SOF of the battery module 102. For example, the weighting factor can depend on one or more of a cellular structure of a battery of the plurality of batteries 106, a material of the casing 112, an application environment, a usage environment (e.g., an electric vehicle), or the like. In this manner, the weighting factor can incorporate and factor additional context associated with the SOF for the battery module 102, which can improve a result of an analysis of the battery module 102 for reuse. For example, the estimate of the value of the SOF above a first value can be indicative that the battery module 102 may be suitable for reuse in an industrial application. For example, the estimate of the value of the SOF above a second value can be indicative that the battery module 102 may be suitable for reuse in a residential application. For example, the estimate of the value of the SOF above a third value can be indicative that the battery module 102 may be suitable for reuse in a commercial application.

Additionally, in FIG. 9B, in the method 900, at an operation 924, for example, the label affixing component 148 can affix, to the battery module 102, a label that includes a value of the SOH. For example, the label can include a barcode that represents the value of the SOH. For example, the barcode can include a quick-response (QR) code.

Additionally, at an operation 926, for example, the imaging component 142 can cause an image, of a label affixed to the battery module 102, to be produced. For example, the label can include information about the SOH.

Additionally or alternatively, at an operation 928, for example, the communications circuit 140 can send, to the memory 138 of the battery module 102, the value of the SOH. For example, the battery module 102 can further include the memory 138.

Additionally, at an operation 930, for example, the communications circuit 140 can cause information, about the SOH, to be read from the memory 138 of the battery module 102. For example, the battery module 102 can further include the memory 138.

Additionally, at an operation 932, for example, the activity determination module 150 can determine, from the information about the SOH, information useful for one or more of: (1) a maintenance activity to be performed on the battery module 102 or (2) a diagnostic activity to be performed on the battery module 102.

Detailed embodiments are disclosed herein. However, one of skill in the art understands, in light of the description herein, that the disclosed embodiments are intended only as examples. Therefore, specific structural and functional details disclosed herein are not to be interpreted as limiting, but merely as a basis for the claims and as a representative basis for teaching one of skill in the art to variously employ the aspects herein in virtually any appropriately detailed structure. Furthermore, the terms and phrases used herein are not intended to be limiting but rather to provide an understandable description of possible implementations. Various embodiments are illustrated in FIGS. 1-8, 9A, and 9B, but the embodiments are not limited to the illustrated structure or application.

The flowchart and block diagrams in the figures illustrate the architecture, functionality, and operation of possible implementations of systems, methods, and computer program products according to various embodiments. In this regard, each block in flowcharts or block diagrams may represent a module, segment, or portion of code, which comprises one or more executable instructions for implementing the specified logical function(s). One of skill in the art understands, in light of the description herein, that, in some alternative implementations, the functions described in a block may occur out of the order depicted by the figures. For example, two blocks depicted in succession may, in fact, be executed substantially concurrently, or the blocks may be executed in the reverse order, depending upon the functionality involved.

The systems, components and/or processes described above can be realized in hardware or a combination of hardware and software and can be realized in a centralized fashion in one processing system or in a distributed fashion where different elements are spread across several interconnected processing systems. Any kind of processing system or another apparatus adapted for carrying out the methods described herein is suitable. A typical combination of hardware and software can be a processing system with computer-readable program code that, when loaded and executed, controls the processing system such that it carries out the methods described herein. The systems, components, and/or processes also can be embedded in a computer-readable storage, such as a computer program product or other data programs storage device, readable by a machine, tangibly embodying a program of instructions executable by the machine to perform methods and processes described herein. These elements also can be embedded in an application product that comprises all the features enabling the implementation of the methods described herein and that, when loaded in a processing system, is able to carry out these methods.

Furthermore, arrangements described herein may take the form of a computer program product embodied in one or more computer-readable media having computer-readable program code embodied, e.g., stored, thereon. Any combination of one or more computer-readable media may be utilized. The computer-readable medium may be a computer-readable signal medium or a computer-readable storage medium. As used herein, the phrase "computer-readable storage medium" means a non-transitory storage medium. A computer-readable storage medium may be, for example, but not limited to, an electronic, magnetic, optical, electromagnetic, infrared, or semiconductor system, apparatus, or device, or any suitable combination of the foregoing. More specific examples of the computer-readable storage medium would include, in a non-exhaustive list, the following: a portable computer diskette, a hard disk drive (HDD), a solid-state drive (SSD), a read-only memory (ROM), an erasable programmable read-only memory (EPROM or flash memory), a portable compact disc read-only memory (CD-ROM), a digital versatile disc (DVD), an optical storage device, a magnetic storage device, or any suitable combination of the foregoing. As used herein, a computer-readable storage medium may be any tangible medium that can contain or store a program for use by or in connection with an instruction execution system, apparatus, or device.

Generally, modules, as used herein, include routines, programs, objects, components, data structures, and so on that perform particular tasks or implement particular data types. In further aspects, a memory generally stores such modules. The memory associated with a module may be a buffer or may be cache embedded within a processor, a random-access memory (RAM), a ROM, a flash memory, or another suitable electronic storage medium. In still further aspects, a module as used herein, may be implemented as an application-specific integrated circuit (ASIC), a hardware component of a system on a chip (SoC), a programmable logic array (PLA), or another suitable hardware component (e.g., a central processing unit (CPU), a graphics processing unit (GPU), a field-programmable gate array (FPGA), or the like) that is embedded with a defined configuration set (e.g., instructions) for performing the disclosed functions.

Program code embodied on a computer-readable medium may be transmitted using any appropriate medium, including but not limited to wireless, wireline, optical fiber, cable, radio frequency (RF), etc., or any suitable combination of the foregoing. Computer program code for carrying out operations for aspects of the disclosed technologies may be written in any combination of one or more programming languages, including an object-oriented programming language such as Java^{™}, Smalltalk, C++, or the like, and conventional procedural programming languages such as the "C" programming language or similar programming languages. The program code may execute entirely on a user's computer, partly on a user's computer, as a standalone software package, partly on a user's computer and partly on a remote computer, or entirely on a remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

The terms "a" and "an," as used herein, are defined as one or more than one. The term "plurality," as used herein, is defined as two or more than two. The term "another," as used herein, is defined as at least a second or more. The terms "including" and/or "having," as used herein, are defined as comprising (i.e., open language). The phrase "at least one of...or..." as used herein refers to and encompasses any and all possible combinations of one or more of the associated listed items. For example, the phrase "at least one of A, B, or C" includes A only, B only, C only, or any combination thereof (e.g., AB, AC, BC, or ABC).

Aspects herein can be embodied in other forms without departing from the spirit or essential attributes thereof. Accordingly, reference should be made to the following claims, rather than to the foregoing specification, as indicating the scope hereof.

## Claims

1. A system, comprising:
a stage configured to support a battery module that includes a plurality of batteries;
a measuring component configured to measure, across a range of frequencies, an impedance across the battery module; and
a parameter analysis component comprising:
a processor; and
a memory storing a reuse assessment module including instructions that cause the processor to:
determine a difference between values, at a first frequency and at a second frequency, of a first derivative, with respect to frequency, of a real part of the impedance; and
determine, responsive to the difference being less than a threshold, that the battery module is suitable for reuse.

2. The system of claim 1, wherein the measuring component excludes an impedance tracking sensor.

3. The system of claim 1 or 2, wherein the battery module further includes a casing configured to maintain an arrangement of the plurality of batteries.

4. The system of claim 1, 2 or 3, wherein the difference is an estimate of a value of a state of safety of the battery module.

5. The system of claim 4, wherein using the first derivative of the real part of the impedance mitigates an effect of a condition that interferes with a determination of the estimate of the value of the state of safety, preferably:
wherein the condition comprises at least one of:
a condition of a change in a position between a metal, of the battery module, and a battery of the plurality of batteries,
a condition in which the metal, of the battery module, has magnetization characteristics,
a condition of a change in a contact resistance of a terminal of a battery of the plurality of batteries, or
a condition of solid electrolyte interphase growth.

6. The system of claim 4 or 5, wherein the memory further stores a health assessment module including instructions that cause the processor to determine, from information, an estimate of a value of a state of health of the battery module.

7. The system of claim 6, wherein the information comprises at least one of:
historical usage data of the battery module,
location-specific data associated with the battery module,
temperature-dependent data associated with the battery module,
data associated with a fleet associated with a vehicle associated with the battery module,
impedance data associated with the battery module, or
a visual inspection of the battery module, preferably:
wherein the impedance data was measured at a frequency less than a third frequency, the third frequency being a frequency at which breakdown of chemicals within the batteries occurs and an effect of ions increases,
and/or
wherein the visual inspection comprises a machine vision inspection of an image of the battery module.

8. The system of claim 6, wherein the information comprises at least one of:
the impedance across the battery module,
a measure of a voltage of the battery module, or
a measure of a temperature of the battery module.

9. The system of claim 6, 7 or 8, wherein:
the estimate of the value of the state of health above:
a first threshold is indicative that the battery module is suitable for reuse in a building, and
a second threshold is indicative that the battery module is suitable for reuse in a vehicle, and
the second threshold is greater than the first threshold.

10. The system of any of claims 6 to 9, wherein the memory further stores a functionality assessment module including instructions that cause the processor to multiply the estimate of the value of the state of safety by the estimate of the value of the state of health to produce an estimate that is proportional to a value of a state of functionality of the battery module, preferably
wherein the estimate of the value of the state of functionality above:
a first value is indicative that the battery module is suitable for reuse in an industrial application,
a second value is indicative that the battery module is suitable for reuse in a residential application, and
a third value is indicative that the battery module is suitable for reuse in a commercial application.

11. The system of any of claims 6 to 10, further comprising at least one of:
a label affixing component configured to affix, to the battery module, a label that includes a value of the state of health, or
a communications circuit configured to send, to a memory of the battery module, the value of the state of health.

12. The system of any of claims 6 to 11:
further comprising at least one of:
an imaging component configured to cause an image, of a label affixed to the battery module, to be produced, wherein the label includes information about the state of health, or
a communications circuit configured to cause the information, about the state of health, to be read from a memory of the battery module,
wherein the memory, of the system, further stores an activity determination module including instructions that cause the processor to determine, from the information about the state of health, information useful for at least one of:
a maintenance activity to be performed on the battery module, or
a diagnostic activity to be performed on the battery module.

13. A method, comprising:
supporting, by a stage, a battery module that includes a plurality of batteries;
measuring, by a measuring component and across a range of frequencies, an impedance across the battery module;
determining, by a processor, a difference between values, at a first frequency and at a second frequency, of a first derivative, with respect to frequency, of a real part of the impedance; and
determining, by the processor responsive to the difference being less than a threshold, that the battery module is suitable for reuse.

14. The method of claim 13, wherein the plurality of batteries comprise lithium-ion batteries,
and/or
wherein both the first frequency and the second frequency are greater than a third frequency, the third frequency being a frequency at which breakdown of chemicals within the batteries occurs and an effect of ions increases.

15. A non-transitory computer-readable medium for analyzing a battery module for possible reuse, the non-transitory computer-readable medium including instructions that, when executed by one or more processors, cause the one or more processors to:
determine a difference between values, at a first frequency and at a second frequency, of a first derivative, with respect to frequency, of a real part of an impedance across the battery module, measured across a range of frequencies, the battery module including a plurality of batteries, the battery module supported by a stage; and
determine, responsive to the difference being less than a threshold, that the battery module is suitable for reuse.
